# FASCICULE DE BREVET EUROPEEN

(11) **EP 2 005 252 B1**
(45) Date de publication et mention de la délivrance du brevet: **24.06.2009**
(21) Numéro de dépôt: 07731249.4
(22) Date de dépôt: 04.04.2007
(51) Int. Cl.: G03F 7/20

(54) **DISPOSITIF DE COLLECTE DE FLUX DE RAYONNEMENT ELECTROMAGNETIQUE DANS L'EXTREME ULTRAVIOLET**
EINRICHTUNG ZUM SAMMELN VON FLUß ELEKTROMAGNETISCHER STRAHLUNG IM EXTREMEN ULTRAVIOLETTBEREICH
DEVICE FOR COLLECTING FLUX OF ELECTROMAGNETIC RADIATION IN THE EXTREME ULTRAVIOLET

(30) Priorité: 07.04.2006 FR 0603116
(43) Date de publication de la demande: 24.12.2008
(73) Titulaire: SAGEM Défense Sécurité, 75015 Paris (FR)
(72) Inventeur: GEYL, Roland, 75015 Paris (FR); PATOZ, Vincent, 75015 Paris (FR); RIGUET, François, 75015 Paris (FR); DUFRESNE DE VIREL, François, 75015 Paris (FR)
(74) Mandataire: Cabinet Plasseraud
(86) Numéro de dépôt international: PCT/FR2007/000573
(87) Numéro de publication internationale: WO 2007/118993

(56) Documents cités:
- EP-A- 1 469 349
- WO-A1-20/05031748
- JP-A- 2004 311 814
- US-A- 5 737 137

## Description

La présente invention concerne d'une manière générale le domaine de l'éclairage avec un rayonnement électromagnétique situé dans l'extrême ultraviolet EUV et, de façon plus précise, l'invention concerne des perfectionnements apportés aux dispositifs de collecte de flux de rayonnement électromagnétique dans l'extrême ultraviolet (EUV) émis par une source de rayonnement électromagnétique EUV, lesdits dispositifs comportant au moins un étage collecteur agencé comme exposé dans le préambule de la revendication 1.

Par « extrême ultraviolet », on entend désigner les rayonnements électromagnétiques ayant une longueur d'onde inférieure à environ 150 nm, et plus spécifiquement la longueur d'onde de 13,5 nm dont il sera plus particulièrement question plus loin.

Dans ce qui suit, on se réfèrera à l'axe optique défini par la source optique et le point image qui en est formé par le dispositif collecteur, et les termes « avant » et « arrière » seront employés en référence au sens allant de la source vers le point image sur cet axe.

La collection du flux lumineux délivré par une source quasi ponctuelle de rayonnement électromagnétique telle qu'une lampe à arc n'est pas une chose aisée lorsque l'on souhaite collecter la plus grande quantité possible de photons émis par la source dans l'espace environnant.

Ce souci devient d'autant plus aigu lorsque l'équipement dans lequel sont intégrés la source et le dispositif collecteur de flux lumineux doit être optimisé au mieux vis-à-vis du paramètre de flux lumineux utile pour le procédé mis en oeuvre.

La microlithographie optique est typiquement un domaine pour lequel des équipements coûteux doivent produire la plus grande quantité de puces silicium par heure en insolant une résine photosensible déposée sur des tranches (wafer) de silicium dans lesquelles les puces seront ensuite découpées.

Il y a quelques années la microlithographie optique utilisait des sources du type lampe à arc de mercure en sélectionnant une des raies spectrales dudit arc de mercure, typiquement à des longueurs d'onde de 435 ou 365 nm.

Actuellement, pour graver des motifs de plus en plus fins, les machines de microlithographie utilisent des longueurs d'onde plus courtes, typiquement de 248 nm et de 193 nm, délivrées par des lasers de puissance du type KrF ou ArF. La collection du flux lumineux s'en trouve facilitée.

Mais le besoin de gravure de motifs toujours plus fins sur les puces amène à envisager des longueurs d'onde encore plus courtes fournies par des sources de nouveaux types.

Le rayonnement extrême ultraviolet EUV à la longueur d'onde de 13,5 nm est actuellement envisagé pour la prochaine génération d'appareils de microlithographie optique faisant l'objet de développements importants dans toutes les technologies impliquées dans les diverses étapes du processus de microlithographie optique :
- réalisation de masque recevant un motif objet destiné à être projeté par réduction sur la tranche de silicium (wafer),
- réalisation de dispositifs optiques de projection à haute résolution destinés à réaliser ladite projection,
- réalisation de dispositifs optiques d'illumination destinés à mettre en forme le flux collecté pour l'injecter sur le masque et l'optique de projection,
- réalisation de dispositifs optiques de collecteurs captant le maximum de flux lumineux fourni par la source,
- réalisation de sources EUV puissantes, stables et fiables,
- réalisation de machines (scanners) manipulant et positionnant les tranches de silicium et les masques face aux dispositifs optiques et assurant la meilleure précision de positionnement et la meilleure vitesse d'exécution.

Des recherches importantes ont été effectuées sur les sources de rayonnements électromagnétiques situés dans le domaine de l'extrême ultraviolet. Ces sources appartiennent à deux grandes catégories, à savoir les sources du type à plasma pulsé par laser ("Laser Pulsed Plasma") et les sources du type à plasma à décharge capillaire ("Capillary Discharge Plasma").

La principale caractéristique de ces deux types de sources est d'avoir un élément émetteur de lumière quasi ponctuel, c'est-à-dire d'une taille qui est typiquement de l'ordre du millimètre, mais capable de rayonner dans un espace angulaire important pouvant atteindre l'hémisphère, voire plus.

Une autre caractéristique des sources EUV au vu des puissances nécessaires aux applications microlithographiques réside dans le fait qu'elles délivrent beaucoup de photons utiles, mais aussi d'autres éléments indésirables :
- des photons situés en dehors de la bande spectrale utile,
- des ions et autres particules éjectés à haute vitesse qui peuvent éroder la surface des éléments optiques placés trop près de la source,
- des débris divers venant aussi se déposer sur la surface des éléments optiques du dispositif collecteur de flux lumineux,
- un rayonnement thermique intense, partiellement absorbé par les éléments optiques du dispositif collecteur de flux lumineux qui subissent alors un échauffement indésirable.
   Ainsi, la résistance du dispositif collecteur de flux lumineux à ces nombreuses agressions est un élément critique majeur qui doit être résolu pour autoriser le déploiement effectif de la technologie EUV dans le domaine de la microlithographie. L'un des objets de la présente invention est d'apporter une réponse innovante à cette problématique.
   Le rayonnement électromagnétique EUV, qui est de courte longueur d'onde, est facilement absorbé par les surfaces sur lesquelles il est conduit à se réfléchir. Pour améliorer cette réflectivité, il est connu
- de réfléchir le rayonnement à l'aide d'une réflexion rasante limitée de 10 à 15° maximum (par rapport à la surface réfléchissante ou à son plan tangent) pour obtenir une réflectivité de 80% et plus sur des métaux tels que le ruthénium ou le molybdène déposés sur la surface polie du miroir réflecteur,
- de réfléchir le rayonnement en incidence quasi normale sur la surface polie d'un miroir réflecteur sur laquelle a été déposé un ensemble de couches minces qui, par le phénomène physique d'interférences constructives, procurent une réflectivité de l'ordre de 65 à 70% ; cependant, un inconvénient réside dans le fait que, lorsque l'incidence du rayonnement s'éloigne trop de l'incidence normale, la réflectivité diminue même si les épaisseurs des diverses couches sont optimisées pour tenir compte de l'incidence exacte des rayons.

La quantité de flux lumineux qui est collectée et effectivement transmise aux modules optiques suivants de la machine de microlithographie est un autre élément critique. Tout gain en pourcentage du flux lumineux collecté par rapport au flux lumineux émis par la source permet de gagner en cadence de production et/ou de réduire le besoin en puissance effective de la source, de réduire donc sa puissance d'agression des éléments optiques du collecteur et de gagner ainsi en durée de vie utile de l'équipement ainsi que sur le coût effectif de l'installation.

Un collecteur de flux simple, efficace et couramment utilisé, notamment dans les projecteurs de cinéma, consiste en un miroir collecteur en forme d'ellipsoïde de révolution dans lequel la source est placée à l'un des foyers, le point image étant formé à l'autre foyer. Ce dispositif a l'avantage d'être simple et limité à un seul composant. Toutefois, il ne peut pas être transposé au domaine EUV pour plusieurs raisons. Une première raison réside dans le fait que le flux collecté est formé avec le rayonnement émis par la source vers l'arrière, puis réfléchi vers l'avant, c'est-à-dire qu'il « traverse » la source pour être focalisé en avant de celle-ci ; or les sources EUV sont des dispositifs complexes et volumineux (typiquement 30 à 40 cm de diamètre pour un point source lumineux de 1 mm environ) : une telle source placée au foyer du collecteur ellipsoïdal bloquerait le flux réfléchi par le miroir. Une deuxième raison tient au fait que les incidences des rayons sur la surface utile du collecteur varient fortement selon l'emplacement de la réflexion sur la surface du miroir, depuis une incidence quasi normale au centre du miroir ellipsoïdal jusqu'à des incidences presque rasantes vers le bord du miroir ; le traitement de la surface réfléchissante pour assurer la réflexion dans le domaine EUV doit donc changer entièrement de nature entre le centre et le bord du miroir, ce qui est très complexe, voire impossible à réaliser au moins dans des conditions économiques acceptables. De ce fait, malgré son avantage de principe, cette solution ne peut pas être retenue.

Le mode de collection du flux EUV communément adopté actuellement, inspiré de la conception des télescopes pour rayons X, consiste à exploiter des miroirs à incidence rasante et à utiliser des réflecteurs de forme quasi cylindrique disposés les uns à la suite des autres et combinés en les insérant les uns dans les autres, de sorte que le flux lumineux collecté est dévié par réflexions successives en incidences rasantes et est constitué d'anneaux angulaires successifs avec des zones intermédiaires occultées dans lesquelles le flux est perdu. Un autre inconvénient de cette technique connue réside dans le fait que, pour capter une portion significative de la lumière émise par la source, il faut approcher les premiers éléments à une faible distance de la source : dans des dispositifs réalisés sur ce principe, les premiers éléments optiques sont placés à une distance de 10 à 15 cm de la source et les agressions par érosion, contamination, échauffement deviennent alors très sérieuses ; la durée de vie effective du dispositif collecteur reste limitée (voir par exemple le document US2005/094764).

Le document EP 1 469 349 divulgue un dispositif collecteur pour flux EUV basé sur l'utilisation d'un miroir concave et d'un miroir convexe selon une disposition « télescope à deux miroirs du type Cassegrain ». Cet agencement souffre d'une efficacité de collection lumineuse insuffisante et ne constitue pas une réponse adéquate au problème posé, notamment de par les angles d'incidence élevés des rayons arrivant sur le second miroir convexe.

Le document WO 2005/031748 présente un agencement de collecteur basé sur un grand miroir concave qui forme une image de la source décalée latéralement par rapport à la source ; le flux lumineux est ensuite renvoyé vers l'avant. Ce dispositif connu souffre d'un manque d'efficacité de collection lumineuse due à une limitation de l'étendue optique collectée par le grand miroir et due aussi à une trop grande proximité du miroir secondaire de la source elle-même qui gêne le cheminement des rayons, ainsi qu'à la présence de divers dispositifs destinés au captage ou à la déviation des particules ou débris émis par la source.

Le document US 2004/223531 présente un dispositif collecteur de flux EUV constitué d'un miroir elliptique donnant une image du point source et complété par un second miroir annulaire captant du flux supplémentaire et le renvoyant sur le même point image grâce à une seconde réflexion sur un élément type « axicon » placé derrière la source. L'inconvénient majeur de cette solution connue est qu'elle ne convient pas aux sources du type « Capillary Discharge Plasma », car le trajet optique passe au travers de la source, là où sont logés les composants optiques, mécaniques et électroniques faisant fonctionner la source. Ce dispositif connu présente donc des conditions d'emploi limitées qui ne peuvent convenir dans le contexte d'une installation de microlithographie.

Le document JP 2005/109502 présente un dispositif comportant un collecteur qui conjugue le point source et le point image de la source et qui est monté sur un support en mouvement. Ce dispositif connu n'apporte pas de réponse performante pour écarter l'inconvénient résultant de la forte déformation des optiques sous le flux thermique de la source.

Le document JP 2004 / 311814 divulgue une source plasma de radiation EUV dont la lumière divergente est transmise vers le point de focalisation intermédiaire via un étage collecteur de rayonnement EUV. Ledit étage collecteur comporte des miroirs convexe et concave segmentés dont la surface est recouverte d'un dépôt réflecteur multicouche.

D'une façon générale; aucun des dispositifs actuellement connus n'est capable de collecter une fraction notable du flux lumineux émis par la source, et leur efficacité reste limitée à quelques pourcents et/ou sont disposés de manière telle que certains au moins de leurs composants sont détériorés rapidement et/ou ils sont trop encombrants pour l'application plus spécifiquement visée dans le domaine de la microlithographie.

On rappelle également les contraintes inhérentes à l'intégration du dispositif collecteur dans une machine de microlithographie fonctionnant avec une source EUV : impossibilité de mettre en oeuvre des lentilles optiques, aucun matériau n'étant transparent pour ces longueurs d'ondes, et nécessité de ne mettre en oeuvre que des composants optiques réflecteurs ; source volumineuse qui impose que la totalité du matériel optique de collection soit situé en avant de cette source ; environnement très encombré qui ne laisse qu'un espace libre restreint pour la mise en place des composants optiques de collection ; distance de focalisation (typiquement de l'ordre de 1,20 m) qui n'est pas susceptible d'être allongée de façon sensible en raison des contraintes d'encombrement général au sein de la machine.

Enfin, il apparaît que, dans le dispositif indiqué au préambule, la partie centrale du cône de lumière émise par la source n'est pas captée par l'étage principal du dispositif collecteur qui vient d'être décrit. Bien que ceci ne soit pas critique car cette partie centrale ne représente qu'une proportion faible du flux total émis par la source, il est cependant intéressant d'avoir le souci d'une collection du maximum de flux émis par la source, afin d'améliorer au maximum les performances du dispositif.

C'est dans ce contexte que l'invention a essentiellement pour but de répondre aux attentes de la pratique et de proposer un dispositif collecteur de flux EUV qui soit remarquablement efficace tout en respectant les nombreuses contraintes précitées.

A ces fins, l'invention propose un dispositif de collecte de flux de rayonnement électromagnétique dans l'extrême ultraviolet (EUV) émis par une source de rayonnement électromagnétique EUV, ledit dispositif comportant au moins un étage collecteur agencé comme exposé dans le préambule de la revendication 1, lequel dispositif de collecte de flux EUV, étant agencé conformément à l'invention, se caractérise en ce qu'il comporte au moins un étage collecteur supplémentaire extérieur situé en avant de l'étage collecteur précédent et comprenant :
- un miroir collecteur concave, percé d'un trou central et placé coaxialement à l'axe optique à l'avant du miroir concave de l'étage collecteur précédent, sa concavité étant tournée vers la source,
- un miroir convexe placé centralement coaxialement à l'axe optique approximativement au niveau du miroir concave de l'étage collecteur précédent, sa convexité étant tournée vers l'avant,
- le miroir collecteur concave étant propre à recevoir la partie du flux émis par la source qui lui parvient en passant entre les bords en vis-à-vis respectivement du miroir collecteur concave de l'étage précédent et du miroir convexe et à renvoyer ce flux vers un point situé en arrière dudit miroir convexe,
- le miroir convexe étant propre à renvoyer, à travers le trou central du miroir collecteur concave dudit étage collecteur supplémentaire extérieur, le flux reçu dudit miroir collecteur concave de l'étage collecteur supplémentaire extérieur vers ledit point image final en avant de la source,
- le miroir collecteur concave et le miroir convexe de l'étage collecteur supplémentaire extérieur étant revêtus d'un dépôt réflecteur multicouche propre à rendre maximale la transmission de rayonnement EUV, ledit dépôt réflecteur comportant plusieurs couches ajustées selon l'angle d'incidence du rayonnement EUV.

Un tel étage collecteur supplémentaire est apte à transmettre quelques pourcents (typiquement de l'ordre de 5%) de la lumière émise par la source, de sorte que le dispositif collecteur équipé des deux étages précités peut fournir au point image environ 30% de la lumière de la source, ce qui représente une amélioration sensible des performances du dispositif, tandis que l'accroissement dimensionnel qui en résulte est acceptable pour que le dispositif collecteur puisse être logé dans l'espace disponible de la machine de microlithographie.

Les dispositions qui viennent d'être exposées conformément à la présente invention permettent de constituer un dispositif de collection de flux optique EUV, et notamment à une longueur d'onde de 13,5 nm. Ce dispositif perfectionné présente l'avantage essentiel de renvoyer la lumière du même côté que le collecteur lui-même sans « traverser » la source, disposition qui est fondamentale eu égard aux dimensions très importantes des sources EUV mises en oeuvre. Il s'agit de plus d'un dispositif à haute efficacité qui collecte une grande quantité de la lumière émise par la source ; typiquement un tel dispositif est capable de transmettre de l'ordre de 20 à 25% de la quantité de lumière émise par la source, à comparer avec la quantité de l'ordre de 6% transmise dans les machines actuelles de microlithographie. Au surplus, le rayon de courbure du miroir collecteur concave est suffisamment important pour que la surface réfléchissante reste à une grande distance, supérieure à environ 250 mm, de la source, et typiquement à une distance comprise entre 400 et 500 mm de la source ; de ce fait, la surface réfléchissante du miroir collecteur concave demeure hors de portée des particules diverses émises par la source ; de cette façon, la densité surfacique d'énergie du rayonnement sur le miroir collecteur concave est réduite et la durabilité de son revêtement réflecteur est assurée. Enfin, on notera que le dispositif collecteur conforme à l'invention délivre un faisceau lumineux conique annulaire qui est dépourvu de discontinuités, à l'inverse du faisceau délivré par les dispositifs à miroirs à incidence rasante.

D'une façon en soi connue de l'homme du métier, on peut donner aux couches du dépôt réflecteur des épaisseurs croissantes avec l'angle d'incidence ; autrement dit, les couches du dépôt réflecteur possèdent des épaisseurs croissantes depuis le bord central jusqu'au bord périphérique des miroirs. Ces dépôts réflecteurs peuvent être constitués de façon en soi connue par des couches alternées de molybdène et de silicium de quelques nanomètres d'épaisseur.

Si besoin en est, on peut prévoir au moins un autre étage collecteur supplémentaire extérieur qui est situé en avant de l'autre étage collecteur supplémentaire précédent dans lequel le miroir convexe est muni d'un trou central et qui comprend :
- un miroir collecteur concave, percé d'un trou central, placé coaxialement à l'axe optique à l'avant du miroir collecteur concave de l'étage collecteur précédent, sa concavité étant tournée vers la source,
- un miroir convexe placé centralement coaxialement à l'axe optique approximativement au niveau du miroir concave de l'étage collecteur précédent, sa convexité étant tournée vers l'avant,
- le miroir collecteur concave étant propre à recevoir la partie du flux émis par la source qui lui parvient en passant entre les bords en vis-à-vis respectivement du trou du miroir convexe de l'étage précédent et du miroir convexe de l'autre étage et à renvoyer ce flux vers un point situé en arrière dudit miroir convexe,
- le miroir convexe étant propre à renvoyer, à travers le trou central du miroir collecteur concave dudit autre étage collecteur supplémentaire, le flux reçu dudit miroir collecteur concave de l'autre étage collecteur supplémentaire extérieur vers ledit point image final en avant de la source,
- le miroir collecteur concave et le miroir convexe de l'autre étage collecteur supplémentaire extérieur étant revêtus d'un dépôt réflecteur multicouche propre à rendre maximale la transmission de rayonnement EUV, ledit dépôt réflecteur comportant plusieurs couches ajustées selon l'angle d'incidence du rayonnement EUV.

Cependant, l'accroissement de la quantité de lumière procuré par cet autre étage supplémentaire extérieur reste limité à quelques pourcents, typiquement de l'ordre de 2 à 3%.

Toutefois pour éviter un allongement axial excessif du dispositif collecteur, il est envisageable de prévoir un étage collecteur supplémentaire intérieur qui est situé en arrière d'un étage collecteur supplémentaire extérieur dans lequel le miroir convexe est muni d'un trou central et qui comprend :
- un miroir collecteur concave, placé coaxialement à l'axe optique à l'arrière du miroir convexe de l'étage collecteur supplémentaire extérieur et percé d'un trou central, qui est propre à recevoir le flux émis par ladite source et à renvoyer ce flux vers un point situé en arrière de la source, ledit miroir concave de l'étage collecteur supplémentaire intérieur étant revêtu d'un dépôt réflecteur multicouche propre à rendre maximale la transmission de rayonnement EUV, ledit dépôt réflecteur comportant plusieurs couches ajustées selon l'angle d'incidence du rayonnement EUV, et
- un miroir convexe placé centralement coaxialement à l'axe optique en arrière du miroir concave de l'étage collecteur supplémentaire intérieur et propre à renvoyer, à travers le trou central du miroir concave de l'étage collecteur supplémentaire intérieur, le flux reçu du miroir de l'étage collecteur supplémentaire intérieur vers ledit point image final en avant de la source, ledit miroir convexe de l'étage collecteur supplémentaire intérieur étant revêtu d'un dépôt réflecteur multicouche propre à rendre maximale la transmission de rayonnement EUV, ledit dépôt réflecteur comportant plusieurs couches ajustées selon l'angle d'incidence du rayonnement EUV.

Dans un mode de réalisation simple, on prévoit alors que le miroir concave de l'étage collecteur supplémentaire intérieur soit situé au revers du miroir convexe dudit étage collecteur supplémentaire extérieur.

Certes, le miroir convexe mis en oeuvre dans l'étage collecteur supplémentaire intérieur qui vient d'être décrit est relativement rapproché de la source et va donc être soumis aux bombardements des particules émises par celle-ci. Toutefois, c'est la face arrière du miroir convexe qui est exposée, ce qui est sans incidence sur le maintien de la qualité optique de sa surface réfléchissante.

Différents exemples de réalisation concrets peuvent être envisagés à partir des étages supplémentaires qui viennent d'être exposés.

On peut noter que, dans le dispositif conforme aux dispositions principales de l'invention, la partie centrale du cône de lumière émis par la source n'est pas captée. On peut donc envisager, si l'on souhaite améliorer encore la quantité de lumière collectée, d'ajouter un étage collecteur supplémentaire, de sorte que le dispositif collecteur est alors équipé de trois étages collecteurs, à savoir un étage collecteur principal et deux étages collecteurs supplémentaires. Cet agencement peut permettre d'augmenter de quelques pourcents la quantité de lumière collectée, qui peut par exemple passer à une valeur d'environ 32 à 34%. L'étage collecteur supplémentaire dernièrement ajouté peut être un étage supplémentaire extérieur disposé en avant de l'étage supplémentaire précité ; toutefois, le dispositif collecteur devient encombrant selon l'axe optique et peut ne plus être logeable dans l'espace libre disponible. On peut alors avoir recours à un étage collecteur supplémentaire intérieur qui est placé en arrière de l'étage collecteur supplémentaire, entre celui-ci et la source, et qui n'augmente nullement l'encombrement global du dispositif collecteur ; un inconvénient peut toutefois résulter de l'accroissement de poids et de coût du dispositif collecteur ainsi constitué en regard d'un gain relativement modeste de la quantité de lumière collectée.

On soulignera que les miroirs des différents étages peuvent être définis géométriquement et positionnés de manière à ne pas occulter la lumière transmise par les étages situés en arrière, avec les divers faisceaux lumineux passant au ras des bords des miroirs. Il en résulte que les faisceaux lumineux coniques délivrés par les différents étages peuvent se juxtaposer parfaitement, sans discontinuité, et former un faisceau lumineux conique continu.

On peut en outre avoir recours à de nombreux aménagements structurels dans la conception des miroirs qui permettent d'accroître la qualité optique du dispositif collecteur et/ou de faciliter la fabrication et de réduire le coût du dispositif. Notamment, on peut prévoir que l'un au moins des deux miroirs d'au moins un étage collecteur soit réalisé selon un profil asphérique de révolution et/ou que l'un au moins des deux miroirs d'au moins l'étage collecteur principal (dont le plus grand des deux miroirs qui peut typiquement avoir un diamètre de l'ordre de 1,10 m) soit réalisé sous forme segmentée.

L'invention sera mieux comprise à la lecture de la description qui suit de certains modes de réalisation préférés donnés uniquement à titre d'exemples non limitatifs. Dans cette description, on se réfère aux dessins annexés sur lesquels :
- la figure 1 est un schéma optique d'un dispositif collecteur à un étage agencé conformément au préambule de la revendication 1 ;
- la figure 2 est un schéma optique d'un dispositif collecteur agencé conformément à l'invention, montrant l'étage principal de la figure 1 auquel est adjoint un étage supplémentaire extérieur conformément à l'invention ;
- la figure 3 est un schéma optique montrant l'agencement de la figure 2 (dont le faisceau lumineux n'est que partiellement représenté par souci de clarté) auquel est adjoint un autre étage supplémentaire, extérieur, conformément à l'invention ; et
- la figure 4 est un schéma optique montrant l'agencement de la figure 2 (dont le faisceau lumineux n'est que partiellement représenté par souci de clarté) auquel est adjoint un autre étage supplémentaire, intérieur, conformément à l'invention.

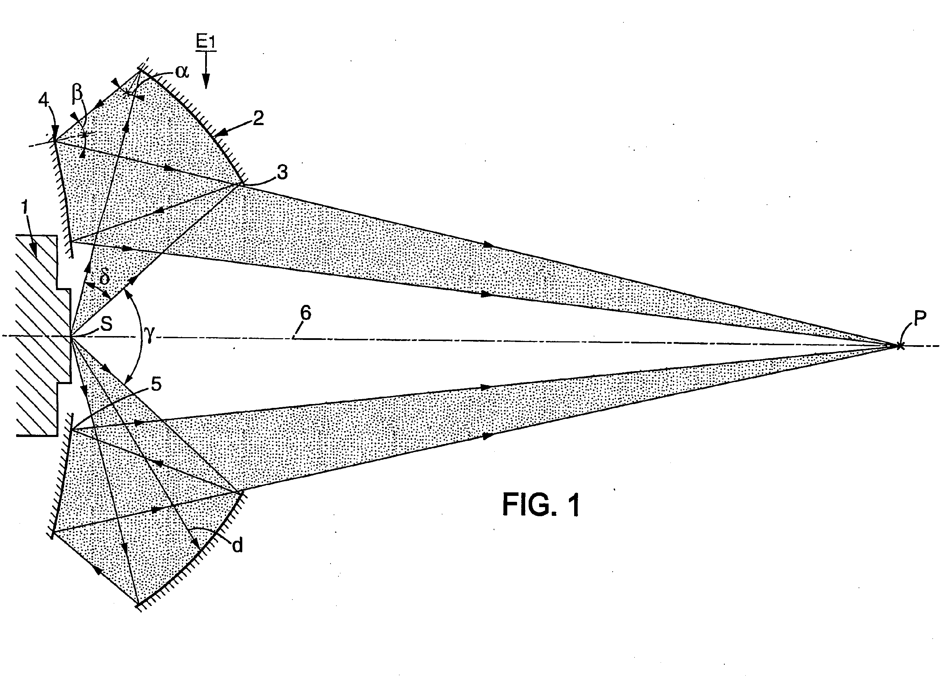

On se reporte tout d'abord à la figure 1 sur laquelle est illustré un dispositif collecteur de rayonnement électromagnétique ayant une longueur d'onde située dans l'extrême ultraviolet EUV -c'est-à-dire inférieure à environ 150 nm, et typiquement de 13,5 nm dans le cadre de l'application à une machine de microlithographie- qui est émis par une source S. Bien que sur le schéma optique la source S soit figurée sous forme ponctuelle, une telle source est, en pratique, un dispositif très volumineux comme schématisé en 1.

Le dispositif collecteur représenté à la figure 1 comporte un seul étage collecteur, qui sera dit étage collecteur principal, désigné par E1, qui est constitué comme il suit.

Un miroir 2 collecteur concave, percé d'un trou 3 central, est placé à l'avant de la source S, sa concavité étant tournée vers la source S. Le miroir 2 concave est propre à recevoir une partie du flux émis par ladite source S et à renvoyer ce flux vers un point situé en arrière de la source S. Le miroir 2 concave est revêtu d'un dépôt réflecteur multicouche propre à rendre maximale la transmission de rayonnement EUV, ledit dépôt réflecteur comportant plusieurs couches ajustées selon l'angle d'incidence du rayonnement EUV.

Un miroir 4 convexe est placé en arrière du miroir 2 concave, approximativement au niveau de la source S, sa convexité étant tournée vers l'avant. Le miroir 4 convexe est percé d'un trou 5 central propre à laisser passer le flux émis par la source S vers le miroir 2 concave. Le miroir 4 convexe est propre à renvoyer, à travers le trou 3 central du miroir 2 concave, le flux reçu du miroir 2 concave vers un point image P final situé en avant de la source S et en avant du miroir 2 concave. Le miroir 4 convexe est revêtu d'un dépôt réflecteur multicouche propre à rendre maximale la transmission de rayonnement EUV, ledit dépôt réflecteur comportant plusieurs couches ajustées selon l'angle d'incidence du rayonnement EUV.

La source S et ledit point image P final définissent un axe optique 6 coaxialement auquel sont disposés lesdits miroirs concave 2 et convexe 4.

Les angles d'incidence α et β du rayonnement EUV respectivement sur les miroirs concave 2 et convexe 4 sont inférieurs à environ 25° par rapport à la normale, comme cela est visible à la figure 1.

Le miroir 2 concave est placé à une distance d de la source S qui est supérieure à environ 250 mm, et qui est typiquement comprise entre 400 et 500 mm, de sorte que le miroir 2 concave se trouve hors d'atteinte des particules émises par la source S.

Le dépôt réflecteur multicouche mentionné plus haut, qui est propre à assurer la réflexion des rayonnements EUV, peut être d'un type connu de l'homme du métier, constitué par des alternances de couches notamment de molybdène et de couches de silicium de quelques nanomètres d'épaisseur. Par le phénomène physique d'interférences constructives, ces couches procurent une réflectivité élevée, de l'ordre de 65 à 70% pour un rayonnement proche de l'incidence normale. L'épaisseur de ces couches est ajustée pour tenir compte de l'incidence exacte des rayons, c'est-à-dire que cette épaisseur (qui serait minimale là où l'incidence serait normale, ce qui n'est pas le cas sur la figure 1) croit d'autant plus que l'incidence s'écarte plus de la normale ; en particulier pour le miroir 2 concave, l'incidence est moindre (bien que non nulle) à proximité du trou central 3 que vers la périphérie externe du miroir, ce qui se traduit par des couches d'épaisseurs croissantes radialement de l'intérieur vers l'extérieur du miroir 2. Au surplus, bien que des couches alternées de molybdène et de silicium soit la solution la plus courante, on peut avoir recours à tout autre matériau approprié ou combinaison de matériaux appropriée. Grâce à cette disposition et en limitant l'angle d'incidence des rayons à environ 25° au plus, on est assuré d'un taux de réflexion optimum de la lumière émise par la source S.

Comme on peut le voir clairement à la figure 1, le faisceau issu du miroir 4 convexe est un faisceau conique annulaire figuré en grisé (les trajets optiques des rayonnements depuis la source S jusqu'au point image P à travers le premier étage collecteur E1 sont repérés par des flèches simples).

Dans un exemple de réalisation typique concernant un dispositif d'éclairage dans une machine de microlithographie, la Demanderesse a pu mesurer qu'au point image P final (distant d'environ 1,20 m de la source S) parvenait une quantité de lumière représentant 20 à 25% de la lumière émise par la source S, ce qui est considérable par comparaison avec la quantité de lumière de l'ordre de 6% recueillie dans les machines connue ayant une configuration différente.

Dans le mode de réalisation du dispositif collecteur de l'invention à un étage collecteur E1 principal qui vient d'être décrit en référence à la figure 1, la fraction de la lumière émise par la source S qui est exploitée par l'étage E1 forme un cône annulaire d'approximativement 40° d'ouverture δ, tandis que la lumière émise dans un cône central d'angle γ d'environ 70° d'ouverture demeure inexploitée.

Pour pallier cette insuffisance, on prévoit conformément à l'invention d'ajouter à l'étage collecteur E1 principal un ou plusieurs étages collecteurs agencés pour recueillir au moins une partie de la lumière émise par la source S dans le cône central d'angle γ.

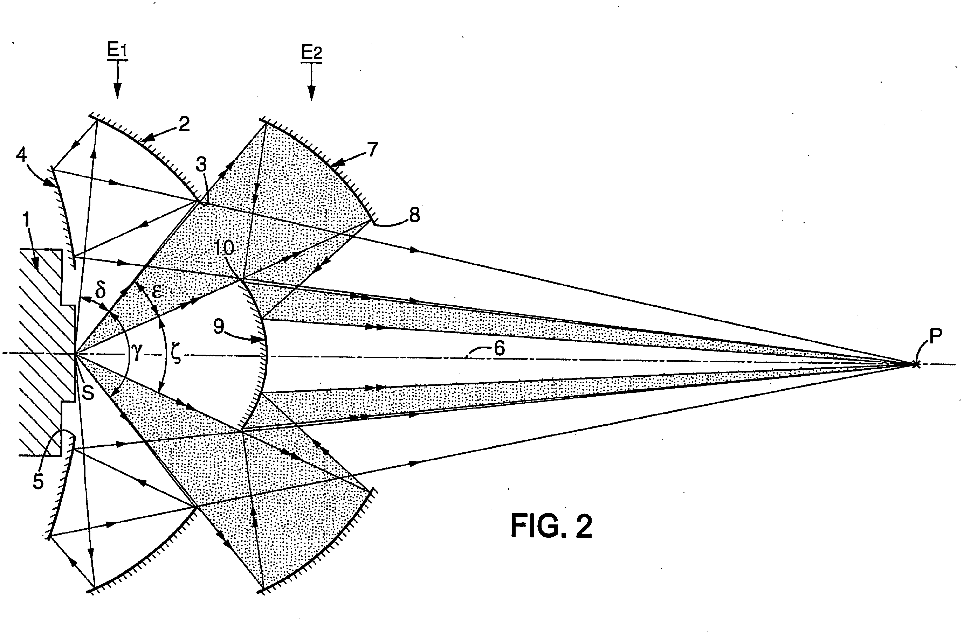

A cette fin, comme illustré à la figure 2, il est proposé d'adjoindre à l'étage collecteur E1 principal au moins un étage collecteur E2 supplémentaire extérieur situé en avant de l'étage collecteur E1 principal et constitué comme il suit.

Un miroir collecteur 7 concave, percé d'un trou 8 central, est placé coaxialement à l'axe optique 6 à l'avant du miroir concave 2 de l'étage collecteur E1 précédent, sa concavité étant tournée vers la source S.

Un miroir 9 convexe est placé centralement coaxialement à l'axe optique 6 approximativement au niveau du miroir concave 2 de l'étage collecteur E1 précédent, sa convexité étant tournée vers l'avant.

Le miroir collecteur 7 concave est propre à recevoir la partie du flux émis par la source S qui lui parvient en passant entre les bords en vis-à-vis 3 du miroir collecteur 2 concave de l'étage E1 précédent et 10 du miroir 9 convexe et à renvoyer ce flux vers un point situé en arrière dudit miroir 9 convexe.

Le miroir 9 convexe est propre à renvoyer, à travers le trou 8 central du miroir collecteur 7 concave dudit étage collecteur E2 supplémentaire, le flux reçu dudit miroir collecteur 7 concave de l'étage collecteur E2 supplémentaire extérieur vers ledit point image P final en avant de la source S.

Comme pour l'étage collecteur E1 principal, le miroir collecteur 7 concave et le miroir 9 convexe de l'étage collecteur E2 supplémentaire sont revêtus d'un dépôt réflecteur multicouche propre à rendre maximale la transmission de rayonnement EUV, ledit dépôt réflecteur comportant plusieurs couches ajustées selon l'angle d'incidence du rayonnement EUV.

Comme on peut le voir clairement à la figure 2, le faisceau traité par l'étage collecteur E2 supplémentaire figuré en grisé (les trajets optiques des rayonnements depuis la source S jusqu'au point image P à travers le deuxième étage collecteur E2 sont repérés par des flèches doubles) s'inscrit étroitement dans le faisceau traité par l'étage collecteur E1 principal, les deux faisceaux étant adjacents sans discontinuité et fournissant conjointement, vu du point image P, un faisceau lumineux unique.

Dans l'agencement conforme à l'invention illustré à la figure 2, l'étage collecteur E2 supplémentaire est unique et de ce fait le miroir 9 convexe situé centralement peut indifféremment être en forme de coupelle comme illustré ou bien, comme seule sa partie annulaire périphérique est utile, être de forme annulaire comme le sont les miroirs 2 et 4 de l'étage E1.

La mise en oeuvre de l'étage collecteur E2 supplémentaire extérieur permet de recueillir une fraction de l'ordre de 5% de la lumière émise par la source S, de sorte que, se plaçant dans l'hypothèse où l'étage collecteur E1 principal recueille environ 25% de la lumière émise par la source, l'ensemble des deux étages collecte environ 30% de la lumière de la source S, ce qui est considérable.

Dans l'agencement conforme à l'invention du dispositif collecteur de l'invention à un étage collecteur E2 supplémentaire qui vient d'être décrit en référence à la figure 2, la fraction de la lumière émise par la source S qui est exploitée par l'étage E2 forme un cône annulaire d'ouverture ε, tandis que la lumière émise dans un cône central d'ouverture ζ demeure toujours inexploitée.

Ceci peut être considéré comme une insuffisance à laquelle il peut être pallié en ajoutant à l'étage collecteur E2 supplémentaire encore un étage collecteur supplémentaire agencé pour recueillir au moins une partie de la lumière émise par la source S dans le cône central d'ouverture ζ.

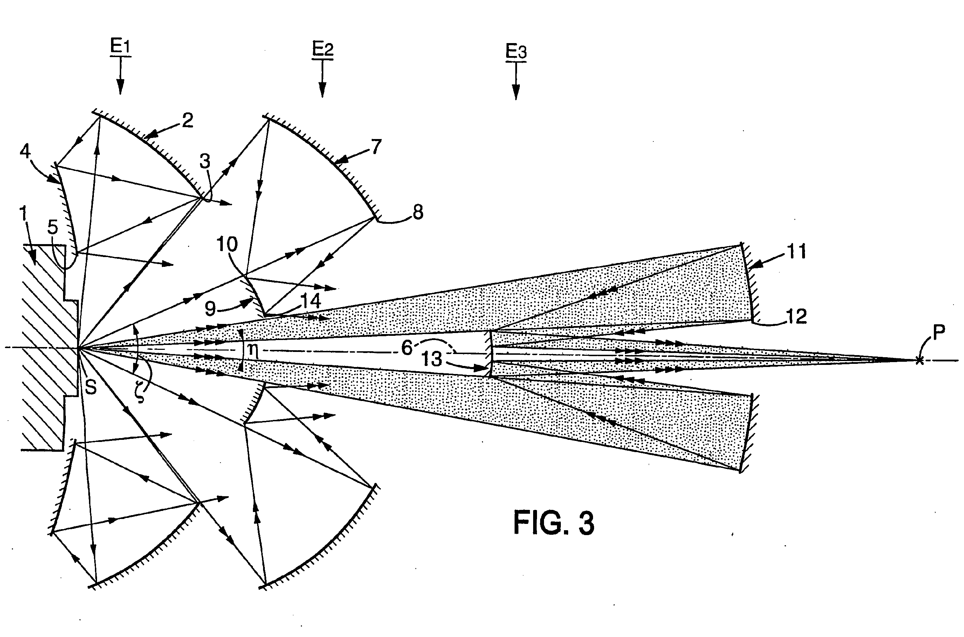

A cette fin, comme illustré à la figure 3, il est possible d'adjoindre à l'étage collecteur E2 supplémentaire un autre étage collecteur E3 supplémentaire extérieur situé en avant de l'étage collecteur E2 supplémentaire et constitué d'une façon analogue comme il suit.

Un miroir collecteur 11 concave, percé d'un trou 12 central, est placé coaxialement à l'axe optique 6 à l'avant du miroir concave 7 de l'étage collecteur E2 précédent, sa concavité étant tournée vers la source S.

Un miroir 13 convexe est placé centralement coaxialement à l'axe optique 6 approximativement au niveau du miroir concave 7 de l'étage collecteur E2 précédent, sa convexité étant tournée vers l'avant.

On notera que dans cette configuration à trois étages collecteurs en cascade, le miroir 9 convexe de l'étage collecteur E2 est muni d'un trou central 14.

Le miroir collecteur 11 concave est propre à recevoir la partie du flux émis par la source S qui lui parvient en passant entre les bords en vis-à-vis respectivement du trou 14 du miroir 9 convexe de l'étage E2 précédent et du miroir 13 convexe de l'étage E3 et à renvoyer ce flux vers un point situé en arrière dudit miroir 13 convexe.

Le miroir 13 convexe est propre à renvoyer, à travers le trou 12 central du miroir collecteur 11 concave dudit étage collecteur E3 supplémentaire, le flux reçu dudit miroir collecteur 11 concave de l'étage collecteur E3 supplémentaire extérieur vers ledit point image P final en avant de la source S.

Comme pour les étages collecteurs E1 et E2, le miroir collecteur 11 concave et le miroir 13 convexe de l'étage collecteur E3 supplémentaire extérieur sont revêtus d'un dépôt réflecteur multicouche propre à rendre maximale la transmission de rayonnement EUV, ledit dépôt réflecteur comportant plusieurs couches ajustées selon l'angle d'incidence du rayonnement EUV.

Comme on peut le voir clairement à la figure 3, le faisceau traité par l'étage collecteur E3 supplémentaire extérieur figuré en grisé (les trajets optiques des rayonnements depuis la source S jusqu'au point image P à travers le troisième étage collecteur E3 sont repérés par des flèches triples, les trajets optiques des étages E1 et E2 n'étant tracés que partiellement pour que la représentation de la figure 3 demeure mieux lisible) s'inscrit étroitement dans le faisceau traité par l'étage collecteur E2 supplémentaire, les trois faisceaux issus des étages E1, E2 et E3 étant adjacents sans discontinuité et fournissant conjointement, vu du point image P, un faisceau lumineux unique.

Le troisième étage collecteur E3 qui vient d'être décrit est apte à recueillir une fraction de l'ordre de quelques pourcents (typiquement de l'ordre de 2 ou 3%) de la lumière émise par la source S, de sorte que l'ensemble du dispositif collecteur à trois étages E1, E2, E3 peut amener au point image P de l'ordre de 32 à 33% de la lumière de la source S.

Bien entendu, il demeure possible de compléter le dispositif collecteur avec un nombre d'étages collecteurs supplémentaires aussi élevé que souhaité pour tenter de recueillir une quantité maximale de la lumière de la source S ; notamment, un quatrième étage supplémentaire extérieur pourrait être ajouté en avant du troisième étage collecteur E3 pour traiter au moins une partie de la lumière émise par la source S dans le cône d'ouverture η non traité par l'étage E3.

Toutefois, il faut prendre en considération que chaque étage collecteur supplémentaire ne traite qu'une fraction de lumière bien moindre que l'étage collecteur qui le précède. Or, eu égard à la qualité optique des matériels mis en oeuvre et donc de leur coût très élevé et eu égard aussi au poids additionnel élevé de chaque étage supplémentaire, il n'est pas envisageable de multiplier à l'infini le nombre des étages collecteurs.

De façon pratique, un dispositif collecteur à un ou deux étages comme montré à la figure 1 ou 2 est très satisfaisant quant à la quantité de lumière qu'il est apte à amener au point image P et un tel dispositif peut satisfaire à lui seul la plupart des applications.

Cependant, dans les cas où un gain de quelques pourcents s'avère nécessaire, un montage à trois étages collecteurs peut être mis en oeuvre dans des conditions économiques et pondérales acceptables. Le montage à trois étages collecteurs extérieurs comme montré à la figure 3 répond à ces exigences. Toutefois, on notera que, alors que le dispositif collecteur de la figure 1 à un seul étage collecteur principal est d'un faible encombrement axial et que le dispositif collecteur de la figure 2 à deux étages collecteurs demeure encore compact (il s'inscrit globalement dans un cube), par contre l'adjonction d'un troisième étage collecteur extérieur comme montré à la figure 3 entraîne un allongement axial considérable du dispositif collecteur en raison notamment de la très forte inclinaison du faisceau sur l'axe optique 6. Un dispositif aussi long peut ne pas pouvoir être implanté dans des machines où l'espace libre est réduit, comme c'est le cas notamment dans les machines de microlithographie.

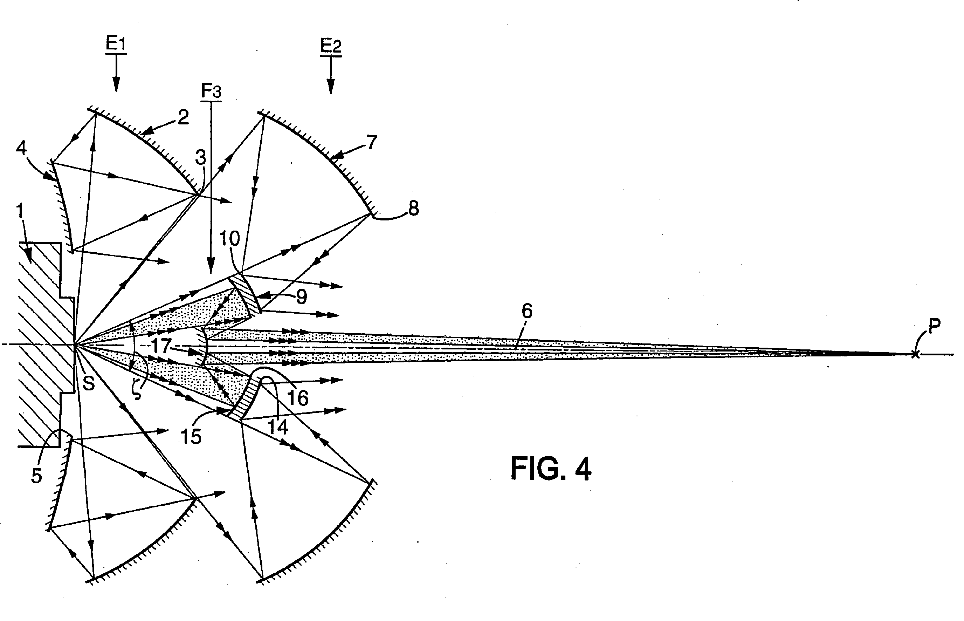

Pour éviter cette difficulté, il est proposé l'implantation d'un étage supplémentaire intérieur, c'est-à-dire un étage F3 supplémentaire situé en arrière du deuxième étage E2 dans lequel le miroir convexe 9 est muni d'un trou 14 central. L'étage F3 est agencé comme suit comme illustré à la figure 4.

Un miroir collecteur 15 concave à concavité tournée vers la source S est placé coaxialement à l'axe optique 6 à l'arrière du miroir convexe 9 de l'étage collecteur E2 supplémentaire extérieur. Le miroir collecteur 15 concave est percé d'un trou 16 central et est propre à recevoir une partie du flux émis par la source S dans le cône d'ouverture ζ et à renvoyer ce flux vers un point situé en arrière.

Dans un exemple de réalisation de structure simple, on peut faire en sorte, comme montré à la figure 4, que le miroir collecteur 15 concave de l'étage collecteur F3 supplémentaire intérieur est situé au revers du miroir 9 convexe de l'étage collecteur E2 supplémentaire extérieur.

Un miroir 17 convexe à convexité tournée vers l'avant est placé centralement coaxialement à l'axe optique 6 en arrière dudit miroir collecteur 15 concave. Le miroir 17 convexe est propre à renvoyer, à travers le trou 16 central du miroir collecteur 15 concave, le flux reçu du miroir 15 concave vers ledit point image P final.

Le miroir collecteur 15 concave et le miroir 17 convexe de l'étage collecteur F3 supplémentaire intérieur sont revêtus d'un dépôt réflecteur multicouche propre à rendre maximale la transmission de rayonnement EUV, ledit dépôt réflecteur comportant plusieurs couches ajustées selon l'angle d'incidence du rayonnement EUV.

Comme on peut le voir clairement à la figure 4, le faisceau traité par l'étage collecteur F3 supplémentaire intérieur figuré en grisé (les trajets optiques des rayonnements depuis la source S jusqu'au point image P à travers le troisième étage collecteur F3 sont repérés par des flèches triples, les trajets optiques des étages E1 et E2 n'étant tracés que partiellement pour que la représentation de la figure 4 demeure mieux lisible) s'inscrit étroitement dans le faisceau traité par l'étage collecteur E2 supplémentaire, les trois faisceaux issus des étages E1, E2 et F3 étant adjacents sans discontinuité et fournissant conjointement, vu du point image P, un faisceau lumineux unique.

Certes, dans l'agencement qui vient d'être décrit, le miroir 17 convexe de l'étage F3 supplémentaire intérieur est relativement proche de la source S. Toutefois, c'est la face arrière de ce miroir 17 convexe qui est tournée vers la source S et qui est soumise au bombardement des particules éjectées par la source, ce qui n'entraîne aucune affectation des qualités optiques de ce miroir dont la face réfléchissante tournée vers l'avant demeure protégée.

L'agencement qui vient d'être décrit en référence à la figure 4 conserve le même encombrement général que le dispositif collecteur à deux étages de la figure 2 et permet de recueillir un supplément de l'ordre de quelques pourcents (typiquement d'environ 2 à 3%) de la quantité de lumière émise par la source S.

Les divers agencements qui ont été décrits ci-dessus en référence aux figures 1 à 4 peuvent donner lieu à de nombreuses variantes de mise en oeuvre pratique. En particulier, on notera que le miroir collecteur 2 concave de l'étage collecteur E1 principal peut avoir un diamètre important supérieur au mètre, typiquement de l'ordre de 1,10 m. Un tel miroir est lourd et difficile à fabriquer. Pour en simplifier la fabrication et la mise au point optique, il est parfaitement envisageable que ce miroir soit réalisé sous forme segmentée. Si besoin en est, d'autres miroirs parmi ceux de plus grands diamètres peuvent également être fabriqués de cette manière. Au surplus, on peut prévoir que l'un au moins des deux miroirs de tout ou partie des étages collecteurs soit réalisé selon un profil asphérique de révolution.

## Revendications

1. Dispositif de collecte de flux de rayonnement électromagnétique dans l'extrême ultraviolet (EUV) émis par une source (S) de rayonnement électromagnétique EUV, ledit dispositif comportant au moins un étage collecteur (E1) principal comprenant :
- un miroir collecteur (2) concave à concavité tournée vers la source (S), placé à l'avant de la source (S) et percé d'un trou (3) central, qui est propre à recevoir le flux émis par ladite source (S) et à renvoyer ce flux vers un point situé en arrière de la source (S), et
- un miroir (4) convexe à convexité tournée vers l'avant, placé en arrière du miroir collecteur (2) concave et propre à renvoyer, à travers le trou (3) central du miroir collecteur (2) concave, le flux reçu du miroir collecteur (2) concave vers un point image (P) final en avant de la source (S) et en avant du miroir collecteur (2) concave, ledit miroir (4) convexe étant placé approximativement au niveau de la source (S) et étant percé d'un trou (5) central propre à laisser passer le flux émis par la source (S) vers le miroir collecteur (2) concave ;
- lesdits miroirs collecteur (2) concave et (4) convexe étant revêtu d'un dépôt réflecteur multicouche propre à rendre maximale la transmission de rayonnement EUV, ledit dépôt réflecteur comportant plusieurs couches ajustées selon l'angle d'incidence du rayonnement EUV ;
- ladite source (S) et ledit point image (P) final définissant un axe optique (6) coaxialement auquel sont disposés lesdits miroirs collecteur (2) concave et (4) convexe ;
- les angles d'incidence du rayonnement EUV sur les miroirs collecteur (2) concave et (4) convexe étant inférieurs à environ 25° par rapport à la normale ; et
- le miroir collecteur (2) concave étant placé à une distance de la source (S) qui est supérieure à environ 250 mm ;
**caractérisé en ce qu'**il comporte au moins un étage collecteur (E2) supplémentaire extérieur situé en avant de l'étage collecteur (E1) précédent et comprenant :
- un miroir collecteur (7) concave, percé d'un trou (8) central et placé coaxialement à l'axe optique (6) à l'avant du miroir concave (2) de l'étage collecteur précédent, sa concavité étant tournée vers la source (S),
- un miroir (9) convexe placé centralement coaxialement à l'axe optique (6) approximativement au niveau du miroir concave (2) de l'étage collecteur précédent, sa convexité étant tournée vers l'avant,
- le miroir collecteur (7) concave étant propre à recevoir la partie du flux émis par la source (S) qui lui parvient en passant entre les bords (3, 10) en vis-à-vis respectivement du miroir collecteur (2) concave de l'étage précédent et du miroir (9) convexe et à renvoyer ce flux vers un point situé en arrière dudit miroir (9) convexe,
- le miroir (9) convexe étant propre à renvoyer, à travers le trou (8) central du miroir collecteur (7) concave dudit étage collecteur supplémentaire extérieur, le flux reçu dudit miroir collecteur (7) concave de l'étage collecteur supplémentaire extérieur vers ledit point image (P) final en avant de la source (S),
- le miroir collecteur (7) concave et le miroir (9) convexe de l'étage collecteur supplémentaire extérieur étant revêtus d'un dépôt réflecteur multicouche propre à rendre maximale la transmission de rayonnement EUV, ledit dépôt réflecteur comportant plusieurs couches ajustées selon l'angle d'incidence du rayonnement EUV.

2. Dispositif de collecte de flux de rayonnement EUV selon la revendication 1, **caractérisé en ce que** le miroir collecteur (2) concave de l'étage collecteur (E1) principal est placé à une distance de la source (S) comprise entre environ 400 et 500 mm.

3. Dispositif de collecte de flux de rayonnement EUV selon la revendication 1 ou 2, **caractérisé en ce que** les couches du dépôt réflecteur possèdent des épaisseurs croissantes avec l'angle d'incidence.

4. Dispositif de collecte de flux de rayonnement EUV selon l'une quelconque des revendications 1 à 3, **caractérisé en ce qu'**il comprend au moins un autre étage collecteur (E3) supplémentaire extérieur qui est situé en avant de l'autre étage collecteur (E2) supplémentaire dans lequel le miroir (9) convexe est muni d'un trou (14) central et qui comprend :
- un miroir collecteur (11) concave, percé d'un trou (12) central, placé coaxialement à l'axe optique (6) à l'avant du miroir collecteur concave (7) de l'étage collecteur (E2) précédent, sa concavité étant tournée vers la source (S),
- un miroir (13) convexe placé centralement coaxialement à l'axe optique (6) approximativement au niveau du miroir concave (7) de l'étage collecteur (E2) précédent, sa convexité étant tournée vers l'avant,
- le miroir collecteur (11) concave étant propre à recevoir la partie du flux émis par la source (S) qui lui parvient en passant entre les bords en vis-à-vis respectivement du trou (14) du miroir (9) convexe de l'étage (E2) précédent et du miroir (13) convexe de l'autre étage (E3) et à renvoyer ce flux vers un point situé en arrière dudit miroir (13) convexe,
- le miroir (13) convexe étant propre à renvoyer, à travers le trou (12) central du miroir collecteur (11) concave dudit autre étage collecteur (E3) supplémentaire, le flux reçu dudit miroir collecteur (11) concave de l'autre étage collecteur (E3) supplémentaire extérieur vers ledit point image (P) final en avant de la source (S),
- le miroir collecteur (11) concave et le miroir (13) convexe de l'autre étage collecteur (E3) supplémentaire extérieur étant revêtus d'un dépôt réflecteur multicouche propre à rendre maximale la transmission de rayonnement EUV, ledit dépôt réflecteur comportant plusieurs couches ajustées selon l'angle d'incidence du rayonnement EUV.

5. Dispositif de collecte de flux de rayonnement EUV selon l'une quelconque des revendications 1 à 4, **caractérisé en ce qu'**il comprend un étage collecteur (F3) supplémentaire intérieur qui est situé en arrière d'un étage collecteur (E2) supplémentaire extérieur dans lequel le miroir convexe (9) est muni d'un trou (14) central et qui comprend :
- un miroir collecteur (15) concave à concavité tournée vers la source (S), placé coaxialement à l'axe optique (6) à l'arrière du miroir (9) convexe de l'étage collecteur (E2) supplémentaire extérieur et percé d'un trou (16) central, qui est propre à recevoir le flux émis par ladite source (S) et à renvoyer ce flux vers l'arrière, et
- un miroir (17) convexe placé centralement coaxialement à l'axe optique (6) en arrière du miroir collecteur (15) concave de l'étage collecteur (F3) supplémentaire intérieur et propre à renvoyer, à travers le trou (16) central du miroir collecteur (15) concave de l'étage collecteur (F3) supplémentaire intérieur, le flux reçu du miroir collecteur (15) concave de l'étage collecteur (F3) supplémentaire intérieur vers ledit point image (P) final en avant de la source,
- ledit miroir collecteur (15) concave et ledit miroir (17) convexe de l'étage collecteur (F3) supplémentaire intérieur étant revêtus d'un dépôt réflecteur multicouche propre à rendre maximale la transmission de rayonnement EUV, ledit dépôt réflecteur comportant plusieurs couches ajustées selon l'angle d'incidence du rayonnement EUV.

6. Dispositif de collecte de flux de rayonnement EUV selon la revendication 5, **caractérisé en ce que** le miroir collecteur (15) concave de l'étage collecteur (F3) supplémentaire intérieur est situé au revers du miroir (9) convexe de l'étage collecteur (E2) supplémentaire extérieur.

7. Dispositif selon la revendication 4,
**caractérisé en ce qu'**il comporte trois étages collecteurs, à savoir un étage collecteur (E1) principal, un premier étage collecteur (E2) supplémentaire extérieur dont le miroir (9) convexe est muni d'un trou (10) central et un second étage collecteur (E3) supplémentaire extérieur situé en avant du précédent.

8. Dispositif selon la revendication 5,
**caractérisé en ce qu'**il comporte au moins trois étages collecteurs, à savoir un collecteur (E1) principal, au moins un étage collecteur (E2) supplémentaire extérieur dont le miroir (9) convexe est muni d'un trou (10) central et un étage collecteur (F3) supplémentaire intérieur situé en arrière du précédent.

9. Dispositif selon l'une quelconque des revendications 1 à 8, **caractérisé en ce que** l'un au moins des deux miroirs d'au moins un étage collecteur est réalisé selon un profil asphérique de révolution.

10. Dispositif selon l'une quelconque des revendications 1 à 9, **caractérisé en ce que** l'un au moins des deux miroirs (2, 4) d'au moins l'étage collecteur (E1) principal est réalisé sous forme segmentée.

## Claims

1. A device for collecting electromagnetic radiation flux in the extreme ultraviolet (EUV) emitted by an EUV electromagnetic radiation source (S), said device comprising at least one main collector stage (E1) comprising:
- a concave collector mirror (2) with concavity directed toward the source (S), placed in front of the source (S) and provided with a central through-hole (3), which is suitable for receiving the flux emitted by said source (S) and for reflecting this flux toward a point situated at the rear of the source (S), and
- a convex mirror (4) with convexity directed toward the front, placed at the rear of the concave collector mirror (2) and suitable for reflecting, through the central through-hole (3) of the concave collector mirror (2), the flux received from the concave collector mirror (2) toward a final image point (P) in front of the source (S) and in front of the concave collector mirror (2), said convex mirror (4) being placed approximately level with the source (S) and being provided with a central through-hole (5) suitable for allowing through the flux emitted by the source (S) toward the concave collector mirror (2);
- said concave (2) and convex (4) collector mirrors being coated with a multilayer reflective deposition suitable for maximizing the transmission of EUV radiation, said reflective deposition comprising several layers adjusted according to the angle of incidence of the EUV radiation;
- said source (S) and said final image point (P) defining an optical axis (6) with which said concave (2) and convex (4) collector mirrors are coaxially arranged;
- the angles of incidence of the EUV radiation on the concave (2) and convex (4) collector mirrors being less than about 25° relative to the normal; and
- the concave collector mirror (2) being placed at a distance from the source (S) which is greater than about 250 mm;
**characterized in that** it comprises at least one exterior additional collector stage (E2) situated in front of the previous collector stage (E1) and comprising:
- a concave collector mirror (7), provided with a central through-hole (8) and placed coaxially with the optical axis (6) in front of the concave mirror (2) of the previous collector stage, its concavity being directed toward the source (S),
- a convex mirror (9) placed centrally, coaxially with the optical axis (6), approximately level with the concave mirror (2) of the previous collector stage, its convexity being directed toward the front,
- the concave collector mirror (7) being suitable for receiving the part of the flux emitted by the source (S) which reaches it by passing between the opposite edges (3, 10) respectively of the concave collector mirror (2) of the previous stage and of the convex mirror (9) and for reflecting this flux toward a point situated at the rear of said convex mirror (9),
- the convex mirror (9) being suitable for reflecting, through the central through-hole (8) of the concave collector mirror (7) of said exterior additional collector stage, the flux received from said concave collector mirror (7) of the exterior additional collector stage toward said final image point (P) in front of the source (S),
- the concave collector mirror (7) and the convex mirror (9) of the exterior additional collector stage being coated with a multilayer reflective deposition suitable for maximizing the transmission of EUV radiation, said reflective deposition comprising several layers adjusted according to the angle of incidence of the EUV radiation.

2. The device for collecting EUV radiation flux as claimed in claim 1, **characterized in that** the concave collector mirror (2) of the main collector stage (E1) is placed at a distance from the source (S) of between about 400 and 500 mm.

3. The device for collecting EUV radiation flux as claimed in claim 1 or 2, **characterized in that** the layers of the reflective deposition have thicknesses that increase with the angle of incidence.

4. The device for collecting EUV radiation flux as claimed in any one of claims 1 to 3, **characterized in that** it comprises at least one other exterior additional collector stage (E3) which is situated in front of the other additional collector stage (E2) in which the convex mirror (9) is provided with a central through-hole (14) and which comprises:
- a concave collector mirror (11), provided with a central through-hole (12), placed coaxially with the optical axis (6) in front of the concave collector mirror (7) of the previous collector stage (E2), its concavity being directed toward the source (S),
- a convex mirror (13) placed centrally, coaxially with the optical axis (6), approximately level with the concave mirror (7) of the previous collector stage (E2), its convexity being directed toward the front,
- the concave collector mirror (11) being suitable for receiving the part of the flux emitted by the source (S) which reaches it by passing between the opposite edges respectively of the hole (14) of the convex mirror (9) of the previous stage (E2) and of the convex mirror (13) of the other stage (E3) and for reflecting this flux toward a point situated at the rear of said convex mirror (13),
- the convex mirror (13) being suitable for reflecting, through the central through-hole (12) of the concave collector mirror (11) of said other additional collector stage (E3), the flux received from said concave collector mirror (11) of the other exterior additional collector stage (E3) toward said final image point (P) in front of the source (S),
- the concave collector mirror (11) and the convex mirror (13) of the other exterior additional collector stage (E3) being coated with a multilayer reflective deposition suitable for maximizing the transmission of EUV radiation, said reflective deposition comprising several layers adjusted according to the angle of incidence of the EUV radiation.

5. The device for collecting EUV radiation flux as claimed in any one of claims 1 to 4, **characterized in that** it comprises an interior additional collector stage (F3) which is situated at the rear of an exterior additional collector stage (E2) in which the convex mirror (9) is provided with a central through-hole (14) and which comprises:
- a concave collector mirror (15) with concavity directed toward the source (S), placed coaxially with the optical axis (6) at the rear of the convex mirror (9) of the exterior additional collector stage (E2) and provided with a central through-hole (16), which is suitable for receiving the flux emitted by said source (S) and for reflecting this flux toward the rear, and
- a convex mirror (17) placed centrally, coaxially with the optical axis (6), at the rear of the concave collector mirror (15) of the interior additional collector stage (F3) and suitable for reflecting, through the central through-hole (16) of the concave collector mirror (15) of the interior additional collector stage (F3), the flux received from the concave collector mirror (15) of the interior additional collector stage (F3) toward said final image point (P) in front of the source,
- said concave collector mirror (15) and said convex mirror (17) of the interior additional collector stage (F3) being coated with a multilayer reflective deposition suitable for maximizing the transmission of EUV radiation, said reflective deposition comprising several layers adjusted according to the angle of incidence of the EUV radiation.

6. The device for collecting EUV radiation flux as claimed in claim 5, **characterized in that** the concave collector mirror (15) of the interior additional collector stage (F3) is situated at the back of the convex mirror (9) of the exterior additional collector stage (E2).

7. The device as claimed in claim 4, **characterized in that** it comprises three collector stages, namely a main collector stage (E1), a first exterior additional collector stage (E2) whose convex mirror (9) is provided with a central through-hole (10) and a second exterior additional collector stage (E3) situated in front of the previous one.

8. The device as claimed in claim 5, **characterized in that** it comprises at least three collector stages, namely a main collector (E1), at least one exterior additional collector stage (E2) whose convex mirror (9) is provided with a central through-hole (10) and an interior additional collector stage (F3) situated at the rear of the previous one.

9. The device as claimed in any one of claims 1 to 8, **characterized in that** one at least of the two mirrors of at least one collector stage is made with an axisymmetric aspherical profile.

10. The device as claimed in any one of claims 1 to 9, **characterized in that** one at least of the two mirrors (2, 4) of at least the main collector stage (E1) is made in segmented form.

## Patentansprüche

1. Vorrichtung zum Sammeln elektromagnetischer Strahlungsflüsse im Extrem-Ultraviolettbereich (EUV), die von einer Quelle (S) elektromagnetischer EUV-Strahlung abgegeben werden, wobei die Vorrichtung mindestens eine Hauptsammelstufe (E1) aufweist, die Folgendes aufweist:
- einen konkaven Sammelspiegel (2) mit zu der Quelle (S) gerichteter Konkavität, der vor der Quelle (S) angeordnet und mit einem zentralen Loch (3) durchbohrt ist, das den von der Quelle (S) abgegebenen Fluss empfangen und diesen Fluss zu einem Punkt lenken kann, der sich hinter der Quelle (S) befindet;
- einen konvexen Spiegel (4), mit nach vorn gerichteter Konvexität, der hinter dem konkaven Sammelspiegel (2) angeordnet ist und durch das zentrale Loch (3) des konkaven Sammelspiegels (2) den von dem konkaven Sammelspiegel (2) empfangenen Fluss, der von dem konkaven Sammelspiegel (2) her empfangen wird, zu einem Endbildpunkt (P) vor der Quelle (S) und vor dem konkaven Sammelspiegel (2) lenken kann, wobei der konvexe Spiegel (4) in etwa auf dem Niveau der Quelle (S) angeordnet und mit einem zentralen Loch (5) durchbohrt ist, das den von der Quelle (S) gesendeten Fluss zu dem konkaven Sammelspiegel (2) durchlassen kann;
- wobei der konkave (2) und der konvexe (4) Sammelspiegel mit einer mehrschichtigen Reflexionsbeschichtung beschichtet sind, die das Übertragen dieser EUV-Strahlung maximal machen kann, wobei die Reflexionsbeschichtung mehrere Schichten aufweist, die gemäß dem Einfallswinkel der EUV-Strahlung eingestellt sind;
- wobei die Quelle (S) und der Endbildpunkt (P) eine optische Achse (6) bilden, koaxial zu der der konkave (2) und der konvexe (4) Sammelspiegel angeordnet sind;
- wobei die Einfallswinkel der EUV-Strahlung auf dem konkaven Sammelspiegel (2) und auf dem konvexen Sammelspiegel (4) kleiner sind als etwa 25° im Vergleich zu der Senkrechten; und
- wobei der konkave Sammelspiegel (2) in einer Entfernung von der Quelle (S) platziert ist, die größer ist als etwa 250 mm ;
**dadurch gekennzeichnet, dass** sie mindestens eine zusätzliche äußere Sammelstufe (E2) aufweist, die sich vor der vorhergehenden Sammelstufe (E1) befindet und Folgendes aufweist:
- einen konkaven Sammelspiegel (7), der mit einem zentralen Loch (8) durchbohrt und koaxial zur der optischen Achse (6) vor dem konkaven Spiegel (2) der vorhergehenden Sammelstufe platziert ist, wobei seine Konkavität zu der Quelle (S) gerichtet ist,
- einen konvexen Spiegel (9), der zentral koaxial zu der optischen Achse (6) in etwa auf dem Niveau des konkaven Spiegels (2) der vorhergehenden Sammelstufe platziert ist, wobei seine Konvexität nach vorn gerichtet ist,
- wobei der konkave Sammelspiegel (7) den Teil der Strömung empfangen kann, der von der Quelle (S) durch Durchgehen zwischen den Rändern (3, 10) in Gegenüberlage jeweils zu dem konkaven Sammelspiegel (2) der vorhergehenden Stufe und dem konvexen Spiegel (9) abgegeben wird, und diesen Fluss zu einem Punkt zurückleiten kann, der sich hinter dem konvexen Spiegel (9) befindet,
- wobei der konvexe Spiegel (9) durch das zentrale Loch (8) des konkaven Sammelspiegels (7) der zusätzlichen äußeren Sammelstufe den von dem konkaven Sammelspiegel (7) der zusätzlichen äußeren Sammelstufe empfangenen Fluss zu dem Endbildpunkt (P) vor der Quelle (S) lenken kann,
- wobei der konkave Sammelspiegel (7) und der konvexe Spiegel (9) der zusätzlichen äußeren Sammelstufe mit einer mehrschichtigen Reflexionsbeschichtung beschichtet sind, die die EUV-Strahlungsübertragung maximal machen kann, wobei die Reflexionsbeschichtung mehrere Schichten aufweist, die gemäß dem Einfallswinkel der EUV-Strahlung eingestellt sind.

2. Vorrichtung zum Sammeln von EUV-Strahlungsflüssen nach Anspruch 1, **dadurch gekennzeichnet, dass** der konkave Sammelspiegel (2) der Hauptsammelstufe (E1) in einer Entfernung von der Quelle (S) platziert ist, die zwischen 400 und 500 mm liegt.

3. Vorrichtung zum Sammeln von EUV-Strahlungsflüssen nach Anspruch 1 oder 2, **dadurch gekennzeichnet, dass** die Schichten der Reflexionsbeschichtung Stärken aufweisen, die mit dem Einfallswinkel zunehmen.

4. Vorrichtung zum Sammeln von EUV-Strahlungsflüssen nach einem der Ansprüche 1 bis 3, **dadurch gekennzeichnet, dass** sie mindestens eine weitere zusätzliche äußere Sammelstufe (E3) aufweist, die sich vor der anderen zusätzlichen Sammelstufe (E2), in der der konvexe Spiegel (9) mit einem zentralen Loch (14) versehen ist, befindet, und Folgendes aufweist:
- einen konkaven Sammelspiegel (11), der mit einem zentralen Loch (12) durchbohrt ist, das koaxial zu der optischen Achse (6) vor dem konkaven Sammelspiegel (7) der vorhergehenden Sammelstufe (E2) platziert ist, wobei seine Konkavität zu der Quelle (S) gerichtet ist,
- einen konvexen Spiegel (13), der zentral koaxial zu der optischen Achse (6) in etwa auf dem Niveau des konkaven Spiegels (7) der vorhergehenden Sammelstufe (E2) platziert ist, wobei seine Konvexität nach vorn gerichtet ist,
- wobei der konkave Sammelspiegel (11) den Teil des Flusses empfangen kann, der von der Quelle (S) abgegebenen wird, der zu ihm durch Durchgehen zwischen den Rändern in Gegenüberlage jeweils zu dem Loch (14) des konvexen Spiegels (9) der vorhergehenden Stufe (E2) und des konvexen Spiegels (13) der anderen Stufe (E3) gelangt, und diesen Fluss zu einem Punkt zurücklenken kann, der sich hinter dem konvexen Spiegel (13) befindet,
- wobei der konvexe Spiegel (13) durch das zentrale Loch (12) des konkaven Sammelspiegels (11) und der anderen zusätzlichen Sammelstufe (E3) den Fluss, den er von dem konkaven Sammelspiegel (11) der anderen zusätzlichen äußeren Sammelstufe (E3) empfangen hat, zu dem Endbildpunkt (P) vor der Quelle (S) zurücklenken kann,
- wobei der konkave Sammelspiegel (11) und der konvexe Spiegel (13) der anderen zusätzlichen äußeren Sammelstufe (E3) mit einer mehrschichtigen Reflexionsbeschichtung beschichtet sind, die die EUV-Strahlungsübertragung maximal machen kann, wobei die Reflexionsbeschichtung mehrere Schichten aufweist, die gemäß dem Einfallswinkel der EUV-Strahlung eingestellt sind.

5. Vorrichtung zum Sammeln von EUV-Strahlungsflüssen nach einem der Ansprüche 1 bis 4, **dadurch gekennzeichnet, dass** sie eine zusätzliche innere Sammelstufe (F3) aufweist, die sich hinter einer zusätzlichen äußeren Sammelstufe (E2) befindet, bei der der konvexe Spiegel (9) mit einem zentralen Loch (14) versehen ist, Folgendes aufweisend:
- einen konkaven Sammelspiegel (15) mit zu der Quelle (S) gerichteter Konkavität, der koaxial zu der optischen Achse (6) hinter dem konvexen Spiegel (9) der zusätzlichen äußeren Sammelstufe (E2) platziert und mit einem zentralen Loch (16) durchbohrt ist, das den Fluss empfangen kann, der von der Quelle (S) abgegebenen wird, und diesen Fluss nach hinten zurücklenken kann, und
- einen konvexen Spiegel (17), der zentral koaxial zu der optischen Achse (6) hinter dem konkaven Sammelspiegel (15) der zusätzlichen inneren Sammelstufe (F3) platziert ist und durch das zentrale Loch (16) des konkaven Sammelspiegels (15) der zusätzlichen inneren Sammelstufe (F3) den Fluss, der von dem konkaven Sammelspiegel (15) der zusätzlichen inneren Sammelstufe (F3) her empfangen wird, zu dem Endbildpunkt (P) vor der Quelle zurücklenken kann,
- wobei der konkave Sammelspiegel (15) und der konvexe Spiegel (17) der zusätzlichen inneren Sammelstufe (F3) mit einer mehrschichtigen Reflexionsbeschichtung beschichtet sind, die die EUV-Strahlungsübertragung maximal machen kann, wobei die Reflexionsbeschichtung mehrere Schichten aufweist, die gemäß dem Einfallswinkel der EUV-Strahlung eingestellt sind.

6. Vorrichtung zum Sammeln von EUV-Strahlungsflüssen nach Anspruch 5, **dadurch gekennzeichnet, dass** der konkave Sammelspiegel (15) der zusätzlichen inneren Sammelstufe (F3) auf der Rückseite des konvexen Spiegels (9) der zusätzlichen äußeren Sammelstufe (E2) liegt.

7. Vorrichtung nach Anspruch 4, **dadurch gekennzeichnet, dass** sie drei Sammelstufen aufweist, nämlich eine Hauptsammelstufe (E1), eine zusätzliche äußere Sammelstufe (E2), deren konvexer Spiegel (9) mit einem zentralen Loch (10) versehen ist, und eine zusätzliche äußere Sammelstufe (E3) vor der vorhergehenden.

8. Vorrichtung nach Anspruch 5, **dadurch gekennzeichnet, dass** sie mindestens drei Sammelstufen aufweist, nämlich einen Hauptkollektor (E1), mindestens eine zusätzliche äußere Sammelstufe (E2), deren konvexer Spiegel (9) mit einem zentralen Loch (10) versehen ist, und eine zusätzliche innere Sammelstufe (F3), die sich hinter der vorhergehenden befindet.

9. Vorrichtung nach einem der Ansprüche 1 bis 8, **dadurch gekennzeichnet, dass** mindestens einer der zwei Spiegel mindestens einer Sammelstufe gemäß einem asphärischen Rotationsprofil hergestellt ist.

10. Vorrichtung nach einem der Ansprüche 1 bis 9, **dadurch gekennzeichnet, dass** mindestens einer der zwei Spiegel (2, 4) mindestens der Hauptsammelstufe (E1) in segmentierter Form hergestellt ist.
